# EUROPEAN PATENT APPLICATION

(11) **EP 4 475 193 A1**
(43) Date of publication of application: **11.12.2024**
(21) Application number: 23177618.8
(22) Date of filing: 06.06.2023
(51) Int. Cl.: H01L 31/0224, H01L 31/0735, H02J 50/30

(54) **PHOTOVOLTAIC POWER CONVERTER**

(71) Applicant: Winse Power Ltd., 33720 Tampere (FI)
(72) Inventor: Aho, Arto, 33870 Tempere (FI); Nikander, Veikka, 33720 Tampere (FI); Isoaho, Riku, 33710 Tampere (FI); Polojärvi, Ville, 33710 Tampere (FI)
(74) Representative: WSL Patentanwälte Partnerschaft mbB

(57) **Abstract**

The present application relates to a photovoltaic power converter comprising a photovoltaic layer, wherein the photovoltaic layer comprises a semiconductor junction, and wherein the photovoltaic layer is designed for absorbing an electromagnetic radiation in a wavelength range, at least part of a semiconductor cover wafer, wherein the semiconductor cover wafer is transparent for the electromagnetic radiation in the wavelength range, and wherein the semiconductor cover wafer is electrically conductive, and a contact metallization, wherein the contact metallization is in electrical contact with the semiconductor cover wafer.

## Description

The present disclosure relates to a photovoltaic power converter comprising a photovoltaic layer, wherein the photovoltaic layer comprises a semiconductor junction, and wherein the photovoltaic layer is designed for absorbing an electromagnetic radiation in a wavelength range.

Furthermore, the present invention relates to a power-by-light system comprising a source for the electromagnetic radiation, and a photovoltaic power converter.

Photovoltaic power converters (PVC) are semiconductor structures converting electromagnetic radiation emitted by a man-made electromagnetic radiation source into electric power. The combination of a man-made electromagnetic radiation source and a photovoltaic power converter is denoted a power by electromagnetic radiation system. Power-by-light systems are used to transfer power to remote devices not being connected to an electricity grid. A descriptive example for the utility of power-by-light systems is the powering of satellites in spacecraft technology. Furthermore, power-by-light systems are frequently used to provide a galvanic isolation between two electric components.

Photovoltaic power converters are optimized for narrowband optical energy transfer. In contrast, solar cell structures are designed to provide high efficiency over an as broad as possible spectrum matching the white electromagnetic spectrum of the sun. The key parameters for optimization of PVCs are the output power of the device as well as the power density of the device. Higher output power enables wider use cases for the power-by-light technology and higher power density enables smaller footprints which in turn promote device miniaturization and decrease of manufacturing costs.

When providing PVCs enabling higher power, there are two major obstacles to be overcome. Towards higher power, an increase in resistive losses is no longer negligible. Resistive losses can be mitigated by providing a front metallization or introducing a thick lateral conductive window layer. Front metallization shades the active area introducing a new loss mechanism and a lateral conductive layer is complicated to fabricate and can only alleviate the problem. Thermal losses can be tackled by decreasing the thermal resistance of the system. In the prior art this has be realized by changing the substrate thickness and/or changing the substrate material.

Compared to the prior art, it is an object of the present invention to provide a photovoltaic power converter and a power-by-light system comprising an increased efficiency.

The above object is solved by a photovoltaic power converter according to independent claim 1. To solve the above object, a photovoltaic power converter is provided, which photovoltaic power converter comprises a photovoltaic layer, wherein the photovoltaic layer comprises a semiconductor junction, and wherein the photovoltaic layer is designed for absorbing an electromagnetic radiation in a wavelength range, at least part of a semiconductor cover wafer, wherein the semiconductor cover wafer is transparent for the electromagnetic radiation in the wavelength range, and wherein the semiconductor cover wafer is electrically conductive, and a contact metallization, wherein the contact metallization is in electrical contact with the semiconductor cover wafer.

It is the basic concept of the present invention to provide at least part of a semiconductor wafer on a front side of the photovoltaic layer. This wafer is denoted the semiconductor cover wafer in the present disclosure. The semiconductor cover wafer enhances the electrical and thermal properties of the photovoltaic power converter.

The terms front and back or front side and back side or front side and back side are used in the present disclosure in order to denote surfaces and parts of the photovoltaic power converter in the direction of electromagnetic radiation propagating from a source for electromagnetic radiation into the photovoltaic power converter. A front surface of an element of the photovoltaic power converter is hit by electromagnetic radiation entering into the device prior to a back surface of the same element.

A semiconductor wafer or a part thereof is a thin slice of bulk semiconductor as it is typically used for the fabrication of integrated circuits. A wafer typically serves as the substrate for a microelectronic device build in or on top of the wafer. In an embodiment of the invention, the semiconductor cover wafer is manufactured in a process including crystal pulling. In particular, the semiconductor cover wafer is not a semiconductor layer grown by epitaxial thin film growth.

As the semiconductor cover wafer is made of a semiconductor it is clearly distinct from a glass cover or a transparent conductive oxide like indium-tin oxide (ITO).

In an embodiment the semiconductor cover wafer comprises a thickness of 10 mm or less or 1 mm or less or 750 micrometer or less or 100 micrometer or less. In an embodiment the semiconductor cover wafer comprises a thickness of 1 micrometer or more or of 1 mm or more. In an embodiment the semiconductor cover wafer comprises a thickness in a range from 1 mm to 10 mm.

The maximum thickness of the semiconductor cover wafer according to an embodiment is chosen depending on its electrical conductivity and photovoltaic converter power density. The higher the conductivity the thinner the semiconductor cover wafer has to be in order to minimize the parasitic optical losses for example due to free carrier absorption. On the other hand, the more power the converter is producing, the thicker the semiconductor cover wafer has to be in order to minimize the resistive losses.

Typically, the photovoltaic power converter is fabricated at wafer level, i.e. a plurality of photovoltaic power converters is processed with a single semiconductor cover wafer, which then is cut into distinct chips. Each chip forms a photovoltaic power converter comprising a part of the semiconductor cover wafer.

Locating the semiconductor cover wafer on a front side of the photovoltaic layer in the sense of the present disclosure means that the semiconductor cover wafer is placed on a side of the photovoltaic layer which when in use faces towards the source of the electromagnetic radiation. Consequently, the semiconductor cover wafer has to exhibit high transparency for the electromagnetic radiation in the same wavelength range in which wavelength range the photovoltaic layer is absorbing. Otherwise, the semiconductor cover wafer would significantly contribute to optical losses of the photovoltaic power converter. In the present application the semiconductor cover wafer is considered transparent for the electromagnetic radiation in the wavelength range once a transparency of the semiconductor cover wafer in the wavelength range is larger than a transparency of the photovoltaic layer in the wavelength range.

In order to enhance the electrical properties of the photovoltaic power converter, the semiconductor cover wafer is electrically conductive and the contact metallization being in electrical contact with the semiconductor cover wafer facilitates a lateral potential equalization of the semiconductor cover wafer and the photovoltaic power converter.

Furthermore, the contact metallization provides contact terminals for the semiconductor cover wafer. The contact metallization in an embodiment is contacted by a contact wire, ribbon or similar, which contact wire e.g. is bonded, welded or soldered to the contact metallization.

Due to the fact that the semiconductor cover wafer is electrically conductive, the footprint of any front contact metallization of the photovoltaic power converter such as fingers or a grid, can be reduced while maintaining the same or even enhanced electrical properties. By a reduction of the area covered by the contact metallization, a larger area of the photovoltaic layer is available for photonic generation of carriers as a shading of the photovoltaic layer by the contact metallization is reduced.

The electrically conductive semiconductor cover wafer also allows an effective current spreading on the front side of the photovoltaic power converter.

Furthermore, an effective heat transfer is provided at a front side of the photovoltaic power converter in proximity to the photovoltaic layer, in which photovoltaic layer the photocurrent and thus the majority of the heat losses are generated.

In an embodiment the material of the semiconductor cover wafer is selected from a group consisting of GaAs (0.55 W cm⁻¹ °C⁻¹), Si (1.3 W cm⁻¹ °C⁻¹), GaP (1.1 W cm⁻¹ °C⁻¹), InP (0.68 W cm⁻¹ °C⁻¹), Ge (0.58 W cm⁻¹ °C⁻¹), InAs (0.27 W cm⁻¹ °C⁻¹) and GaSb (0.32 W cm⁻¹ °C⁻¹), wherein the respective heat conductivity is given in brackets.

In an embodiment an additional optically transparent heat dissipator is bonded onto a front surface of the semiconductor cover wafer. The additional heat dissipator offers better power scaling capabilities. In an embodiment a material of the heat dissipator is selected from group comprising GaAs, Si, SiC and Diamond. In an embodiment the additional heat dissipator contains a further functional structure, e.g. an optical element feature including light trapping and guiding functionalities.

Furthermore, the semiconductor cover wafer in an embodiment allows to provide a secondary component or component array, such as a laser, an LED or a detector to be placed under the photovoltaic layer, i.e. at a back side of the photovoltaic layer.

In an embodiment a secondary component or component array, such as a laser, an LED or a detector is placed on top of the semiconductor cover wafer.

The photovoltaic layer is the part of the photovoltaic power converter which is active. In the photovoltaic layer photons of the electromagnetic radiation generate charge carriers and photovoltage.

In an embodiment of the present invention, the photovoltaic power converter comprises a single photovoltaic layer. In another embodiment, the photovoltaic power converter comprises a plurality of photovoltaic layers. In an embodiment of the present invention, the photovoltaic layer comprises a plurality of vertically series connected semiconductor junctions. The photovoltaic layers can be series connected by using tunnel junctions.

In an embodiment of the present invention, the photovoltaic layer is a single junction photovoltaic layer comprising a single semiconductor junction, only. In a further embodiment of the invention, the photovoltaic layer is a multi-junction architecture comprising a plurality of semiconductor junctions. In an ideal consideration, the number of semiconductor junctions does not affect the ultimate conversion efficiency of the photovoltaic power converter. However, an increasing number of semiconductor junctions increases the output power and the output voltage achieved by the photovoltaic power converter.

A semiconductor junction is a junction between two semiconductors or semiconductor layers. In an embodiment, the semiconductor junction one of a group consisting of a pn junction, a np junction, a pin junction and a nip junction.

In an embodiment the semiconductor junction is a III-V semiconductor junction, a Si semiconductor junction or a Ge semiconductor junction.

In contrast to the semiconductor cover wafer, the photovoltaic layer is manufactured by a method selected from a group consisting of an epitaxial growth, diffusion or implantation. In an embodiment of the present invention, the epitaxial growth is selected from MBE, VPE, MOCVD or LPE and variants thereof.

In order to provide at least one of the functionalities described in the present disclosure, a series resistance between the contact metallization and the semiconductor cover wafer is preferably low. In an embodiment of the present invention, the contact metallization is in direct mechanical contact with the semiconductor cover wafer such that no further layer is provided between the contact metallization and the semiconductor cover wafer.

In an alternative embodiment, at least a mechanical contact enhancing layer or an electrical contact enhancing layer is provided between the semiconductor cover wafer and the contact metallization. In an embodiment at least a plurality of mechanical contact enhancing layers or a plurality of electrical contact enhancing layers are provided between the semiconductor cover wafer and the contact metallization. The mechanical contact enhancing layer or the electrical contact enhancing layer in an embodiment is a semiconductor, a semimetal, or a metal. In such an embodiment the mechanical contact between the contact metallization and the semiconductor cover wafer according to the present disclosure is considered indirect. In an embodiment the contact enhancing layer has a higher doping level than the semiconductor cover wafer in order to provide an enhanced ohmic contact between the semiconductor cover wafer and the contact metallization. The contact enhancing layer reduces the ohmic resistance between the semiconductor cover wafer and the contact metallization.

According to an embodiment of the present invention, the contact metallization is applied on a surface of the semiconductor cover wafer which surface comprises a surface normal vector pointing away from the photovoltaic layer. I.e. the contact metallization is provided on a front surface of the cover wafer. In an embodiment of the present invention, the contact metallization is sunk-in into the front surface of the semiconductor cover wafer. In another embodiment of the present invention, the contact metallization is provided on a side surface of the semiconductor cover wafer. In still a further embodiment the contact metallization is provided on a back surface of the semiconductor cover wafer to the area not covered by the photovoltaic layer.

The sheet resistance is a relevant parameter of the semiconductor cover wafer according to the present invention. On the one hand, the sheet resistance must be low enough to provide the required electrical conductivity. On the other hand, the sheet resistance must be chosen to keep the parasitic optical losses due to free carrier absorption in a reasonable range. As the sheet resistance depends on the material and the thickness of the semiconductor cover wafer the resistivity of the semiconductor cover wafer as a whole has to be considered.

In an embodiment of the present invention, the semiconductor cover wafer has a resistivity of 1 x 10⁴ Ohm centimeter or less, preferably of 1 x 10² Ohm centimeter or less at 300 K. These upper boundaries guarantee a reasonable potential equalisation of the semiconductor cover wafer and the photovoltaic power converter. Preferably the resistivity of the semiconductor cover wafer is as small as possible.

In an embodiment of the present invention, the semiconductor cover wafer has a resistivity in a range from 1 x 10⁻³ Ohm centimeter to 1 x 10⁻¹ Ohm centimeter at 300 K.

In an embodiment the semiconductor cover wafer comprises an area which in a lateral direction extends beyond an area of the photovoltaic layer, wherein at least part of the contact metallization is provided on a back surface of the semiconductor cover wafer.

In an embodiment of the present invention, the photovoltaic layer of the photovoltaic power converter comprises a total area, wherein the contact metallization comprises a busbar metallization and optionally a contact finger metallization, which contact finger metallization is electrically connected to the busbar metallization, wherein an active chip area is defined as the total area of the photovoltaic layer minus an area of the photovoltaic layer covered by the busbar metallization, and wherein 10 % or less or 5 % or less or 3 % or less or 2 % or less or 1 % or less of the active chip area is covered by the contact finger metallization. According to the present disclosure, the active chip area of the photovoltaic layer is the area which is not shaded and thus effectively illuminated and contributes to the photoinduced generation of carriers.

One of the advantages of the semiconductor cover wafer according to the present invention is its electrical conductivity and thus its ability to provide current spreading i.e., equalize the lateral potential of the photovoltaic power converter. Due to the high conductivity of the semiconductor cover wafer, the area covered by at least one contact finger metallization of the contact metallization can be drastically reduced.

In an embodiment of the present invention, there is no finger metallization provided on the semiconductor cover wafer at all. In this case, 0% of the active chip area is covered by the contact finger metallization. The contact metallization without a finger metallization consists of a busbar metallization, only.

In an embodiment of the present invention, the semiconductor cover wafer comprises a n-type doping or a p-type doping. The doping of the semiconductor cover wafer increases its electrical conductivity. In particular, a n-type doped GaAs cover wafer has lower free carrier absorption than a p-type doped GaAs cover wafer with the same conductivity.

In an embodiment of the present invention, the photovoltaic layer is obtained by epitaxial growth, diffusion or implantation on the semiconductor cover wafer. In this embodiment, the semiconductor cover wafer serves as a substrate for the semiconductor structure, in particular of the photovoltaic layer.

According to an embodiment of the present invention, the semiconductor cover wafer comprises GaAs or InP, such that the semiconductor cover wafer is transparent for the electromagnetic radiation in the wavelength range, wherein the smallest wavelength of the wavelength range is equal to or larger than 900 nm.

In an embodiment of the present invention, the semiconductor cover wafer comprises Si such that the semiconductor cover wafer is transparent for the electromagnetic radiation in the wavelength range, wherein a smallest wavelength of the wavelength range is equal to or larger than 1100 nm.

According to an embodiment of the present invention, the semiconductor cover wafer comprises Ge or GaSb, such that the semiconductor cover wafer is transparent for the electromagnetic radiation in the wavelength range, wherein the smallest wavelength of the wavelength range is equal to or larger than 1700 nm.

According to an embodiment of the present invention, the semiconductor cover wafer comprises GaP or GaN, such that the semiconductor cover wafer is transparent for the electromagnetic radiation in the wavelength range, wherein the smallest wavelength of the wavelength range is equal to or larger than 365 nm.

According to an embodiment of the present invention, the semiconductor cover wafer comprises GaP, such that the semiconductor cover wafer is transparent for the electromagnetic radiation in the wavelength range, wherein the smallest wavelength of the wavelength range is equal to or larger than 580 nm.

In an embodiment of the present invention, the photovoltaic layer or a semiconductor structure comprising the photovoltaic layer is bonded onto a back carrier.

In an embodiment the semiconductor cover wafer is the substrate for an epitaxial growth of the photovoltaic layer or a semiconductor structure comprising the photovoltaic layer. In this embodiment the photovoltaic layer or a semiconductor structure comprising the photovoltaic layer is bonded onto the back carrier easily. In another embodiment epitaxial growth of the photovoltaic layer or the semiconductor structure comprising the photovoltaic layer is carried out on a semiconductor substrate wafer opposite the surface of the photovoltaic layer or of the semiconductor structure comprising the photovoltaic layer in contact with the semiconductor cover wafer. In an embodiment this semiconductor substrate wafer is optionally removed after the photovoltaic layer or a semiconductor structure comprising the photovoltaic layer is bonded onto the back carrier.

In an embodiment of the present invention, the back carrier is selected from a group comprising at least a part of a semiconductor back wafer, a metal block, e.g. a copper block, a ceramic submount, a metal diamond composite carrier and a diamond carrier.

In an embodiment, wherein the back carrier is at least part of a semiconductor back wafer, the semiconductor back wafer comprises an active layer. In an embodiment, this active layer is a photovoltaic layer, an electromagnetic radiation emitting layer or an electromagnetic radiation absorbing layer that can generate photocurrent or re-emit photons.

In an embodiment of the present invention, the back carrier comprises a thermal conductivity being larger than a thermal conductivity of the photovoltaic layer, whereby the back carrier forms a heat sink or a path of low thermal resistance towards a heatsink for the photovoltaic layer.

In an embodiment of the present invention, the back carrier is a semiconductor back wafer comprising a material selected from a group consisting of AIN, SiC, Ge, metal diamond composite, Si or diamond. Each of these materials comprises a thermal conductivity which is typically larger than a thermal conductivity of the photovoltaic layer.

In an embodiment a material of the back carrier is selected from a group consisting of AIN (2.85 W cm⁻¹ °C⁻¹ to 3.21 W cm⁻¹ °C⁻¹), 3C-SiC (3.6 W cm⁻¹ °C⁻¹), 4H-SiC (3.7 W cm⁻¹ °C⁻¹), 6H-SiC (4.9 W cm⁻¹ °C⁻¹) and diamond (~20 W cm⁻¹ °C⁻¹), wherein the respective heat conductivity is given in brackets.

In an embodiment, a metallic coating or a dielectric coating or a distributed Bragg reflector is provided on a side of the photovoltaic layer opposite the semiconductor cover wafer, which metallic coating or dielectric coating or distributed Bragg reflector reflects the electromagnetic radiation in the wavelength range. In an embodiment the metallic coating or the dielectric coating or the distributed Bragg reflector is provided between the back carrier and the photovoltaic layer.

Instead of using the semiconductor cover wafer as a substrate for the photovoltaic layer, the photovoltaic power converter according to an embodiment may be provided on a front surface of the photovoltaic layer after fabrication of the photovoltaic layer. Thus, in an embodiment of the present invention, the photovoltaic layer is fabricated on a semiconductor substrate wafer, wherein the semiconductor cover wafer is bonded onto a front surface of the photovoltaic layer or onto a front surface of a semiconductor structure comprising the photovoltaic layer, which front surface is opposite the semiconductor substrate wafer. In this embodiment, the semiconductor substrate wafer is different from the semiconductor cover wafer.

In an embodiment, the semiconductor cover wafer comprises GaAs, InP, Ge, InAs, GaSb, GaN, GaP, SiC, diamond or AllnGaN-on-sapphire, such that the semiconductor cover wafer is transparent for the electromagnetic radiation in the wavelength range.

In an embodiment of the present invention, an anti-reflection coating is provided on the semiconductor cover wafer.

The above object is also solved by a power-by-light system comprising a source for the electromagnetic radiation, and a photovoltaic power converter according to an embodiment as it has been described before in the present disclosure.

In a power-by-light system, the source for the electromagnetic radiation and the photovoltaic power converter are located and arranged such that the electromagnetic radiation generated and emitted by the source is received and converted by the photovoltaic power converter.

Further advantages, features and applications of the present disclosure will become apparent from the following description of embodiments and the corresponding figures attached. In the figures similar elements have been denoted by identical reference numbers.
- Figure 1: is a schematic cross-sectional view of a photovoltaic power converter according to the prior art.
- Figure 2: is a schematic cross-sectional view of a photovoltaic power converter according to an embodiment of the present invention.
- Figure 3: is a schematic cross-sectional view of a photovoltaic power converter according to a second embodiment of the present invention.
- Figure 4: is a schematic cross-sectional view of a photovoltaic power converter according to a third embodiment of the present invention.
- Figure 5: is a schematic cross-sectional view of a photovoltaic power converter according to a fourth embodiment of the present invention.
- Figure 6: is a schematic cross-sectional view of a photovoltaic power converter according to a fifth embodiment of the present invention.
- Figure 7: is a schematic cross-sectional view of a photovoltaic power converter according to a sixth embodiment of the present invention.
- Figure 8: is a schematic cross-sectional view of a photovoltaic power converter according to a seventh embodiment of the present invention.
- Figure 9: is a schematic cross-sectional view of a photovoltaic power converter according to an eighth embodiment of the present invention.
- Figure 10: is a schematic cross-sectional view of a photovoltaic power converter according to a ninth embodiment of the present invention.
- Figure 11: is a schematic cross-sectional view of a photovoltaic power converter according to a tenth embodiment of the present invention.
- Figures 12 a) to c): are schematic top views of prior art contact metallizations.
- Figure 13: is a top view of the embodiment of figure 6, wherein the photovoltaic power converter is drawn semi-transparent.

The terms front and back according to the present disclosure are chosen with reference to the direction of incoming electromagnetic radiation 5 to be converted by the photovoltaic power converter 1, 10.

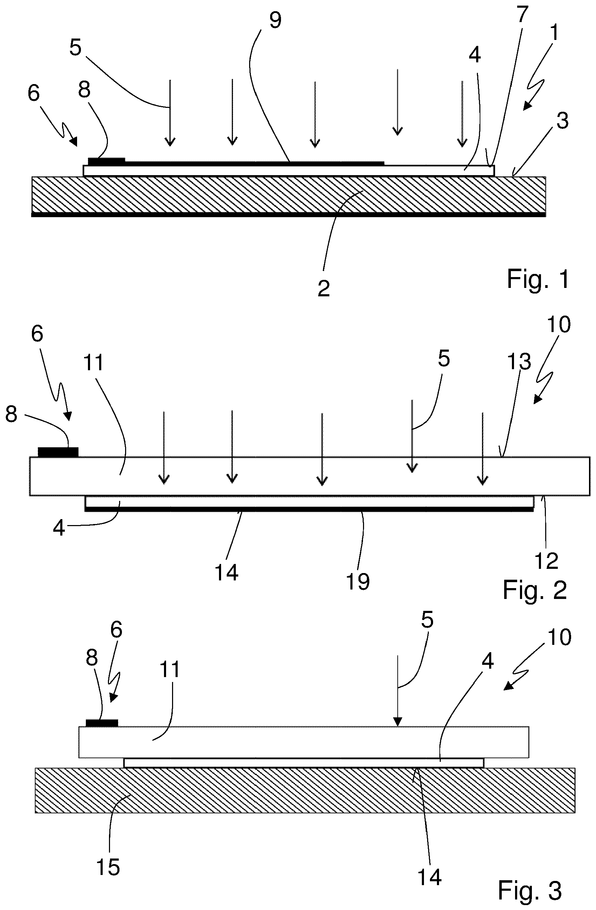

Figure 1 is a schematic cross-sectional view of a photovoltaic power converter 1 according to the prior art. The photovoltaic power converter 1 of the prior art comprises a semiconductor substrate 2. On a front surface 3 of the substrate 2, a semiconductor structure with the photovoltaic layer 4 comprising one or more semiconductor junctions is epitaxially grown, e.g. by MOCVD.

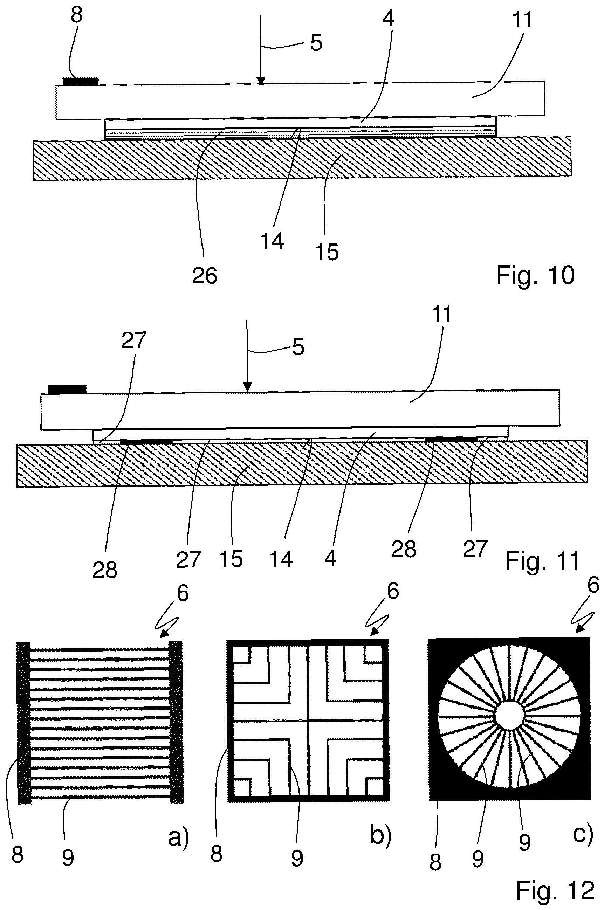

In order to enable carrier extraction, a contact metallization 6 is provided on a front surface 7 of the photovoltaic layer 4. The contact metallization 6 comprises a busbar metallization 8 and a number of contact finger metallizations 9. For illustrative purposes figures 12 a) to c) represent three different layouts of a contact metallizations 6 comprising a busbar metallization 8 and a number of contact finger metallizations 9 each. The contact finger metallizations 9 drastically reduce the overall active area of the photovoltaic layer 4 as the contact finger metallizations 9 shade the photovoltaic layer 4 and thus reduces the efficiency of carrier generation in the photovoltaic layer 4.

In order to enhance the efficiency of carrier generation in the photovoltaic layer 4, in all photovoltaic power converters 10 according to the present invention of figures 2 to 11 a semiconductor cover wafer 11 is provided.

On a back surface 14 of the photovoltaic layer 4 of the photovoltaic power converters 10 a metallic back contact 19 is applied.

In the embodiments of figures 2, 3 and 5 to 11 the semiconductor cover wafer 11 is the substrate for the photovoltaic layer 4. I.e. the photovoltaic layer 4 or a semiconductor structure comprising the photovoltaic layer 4 is epitaxially grown on a back surface 12 of the semiconductor cover wafer 11. In the embodiments shown, the semiconductor cover wafer 11 is of n-doped GaAs. The semiconductor cover wafer has a low electrical resistivity of less than 1 x 10² Ohm cm. The n-doped GaAs is transparent for the electromagnetic radiation 5 to be converted into electrical power. Thus, the electromagnetic radiation 5 to be converted comprises a wavelength range with a smallest wavelength being larger than 900 nm. The electromagnetic radiation 5 to be converted will pass through the transparent semiconductor cover wafer 11 and is then converted in the photovoltaic layer 4.

Due to the n-type doping of the GaAs semiconductor cover wafer 11, the semiconductor cover wafer 11 provides a current spreading. This ability to conduct an electrical current allows a reduction of the area and number of the contact fingers 9 of the contact metallization 6 on a front surface 13 of the semiconductor cover wafer 11. In the embodiments shown, the area of the front surface 13 of the semiconductor cover wafer 11 covered by fingers is reduced to 0, i.e. the contact metallization 6 consists of a busbar metallization 8, only. This in turn enlarges the active area of the photovoltaic layer 4 which is not shaded by any contact fingers 6. Furthermore, in the embodiments shown in the figures an area of the semiconductor cover wafer 11 extends beyond the area of the photovoltaic layer 4. Thus, the busbar metallization 8 is positioned on or in a surface 12, 13, 24 of the semiconductor cover wafer 11 outside of a projection of the front surface 18 of the photovoltaic layer 4 onto a front surface 13 of the semiconductor cover wafer 11. Thus, the entire total chip area of the photovoltaic layer 4 may contribute to the generation of photo generated charge carriers.

Furthermore, the position of the semiconductor cover wafer 11 on top of the photovoltaic layer 4 increases the effective surface area of the chip, facilitating enhanced heat dissipation from the photovoltaic layer 4.

As it is shown for the embodiment of figure 3, providing the semiconductor cover wafer 11 as the substrate for the growth of the photovoltaic layer 4 enables to bond a back surface 14 of the photovoltaic layer 4 onto a back carrier 15. In the embodiment of figure 3, this back carrier 15 is a diamond die enabling an effective heat transfer also from the back side of the photovoltaic layer 4.

In the embodiments of figures 2 and 3 the substrate for epitaxial growth of the photovoltaic layer 4 is formed by the semiconductor cover wafer 11. After growth of the photovoltaic layer 4 the semiconductor cover wafer 11 is turned around such that during operation the electromagnetic radiation 5 is transmitted through the semiconductor cover wafer 11 before reaching the photovoltaic layer 4.

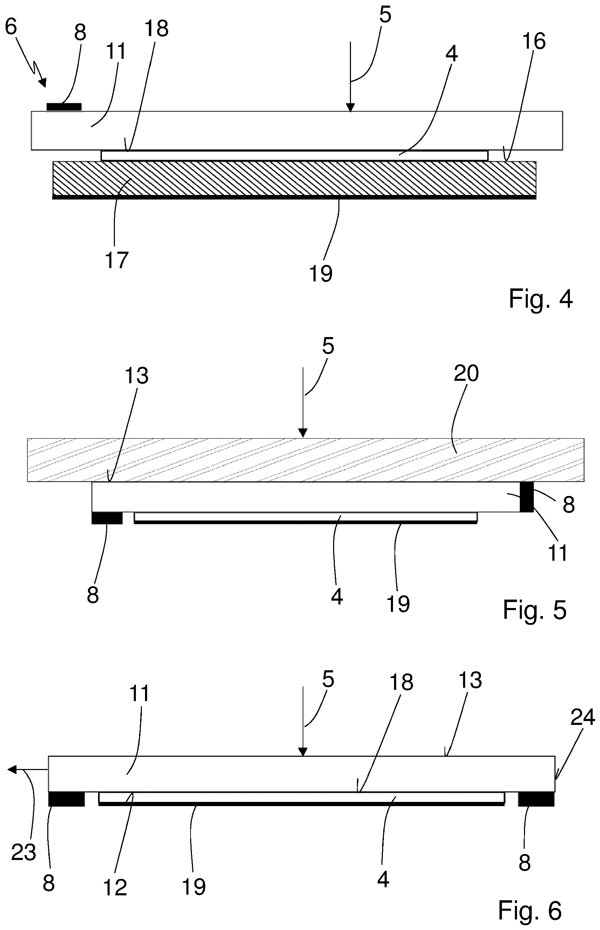

Figure 4 is schematic representation of an alternative embodiment in which the photovoltaic layer 4 is epitaxially grown on a front surface 16 of a semiconductor substrate wafer 17 and the semiconductor cover wafer 11 is bonded onto a front surface 18 of the photovoltaic layer 4.

Figures 5 and 6 illustrate examples of the concept for implementing a semiconductor cover wafer 11 as described with reference to figure 2. I.e. the semiconductor cover wafer 11 is the substrate for the growth of the photovoltaic layer 4. Furthermore, on the front surface 13 of the semiconductor cover wafer 11 a heat dissipator 20 is provided. The heat spreader on the semiconductor cover wafer 11 is transparent for a wavelength range of the electromagnetic radiation 5. In the embodiment depicted in figure 5, the heat dissipator 20 is a Si wafer. The additional heat dissipator 20 offers better power scaling capabilities. In addition, the heat dissipator 20 may contain other functional element features like high energy radiation shielding for space applications or light guiding functionalities.

Figures 6 to 8 and 13 illustrate different positions of the contact metallization 6 consisting of the busbar metallization 8.

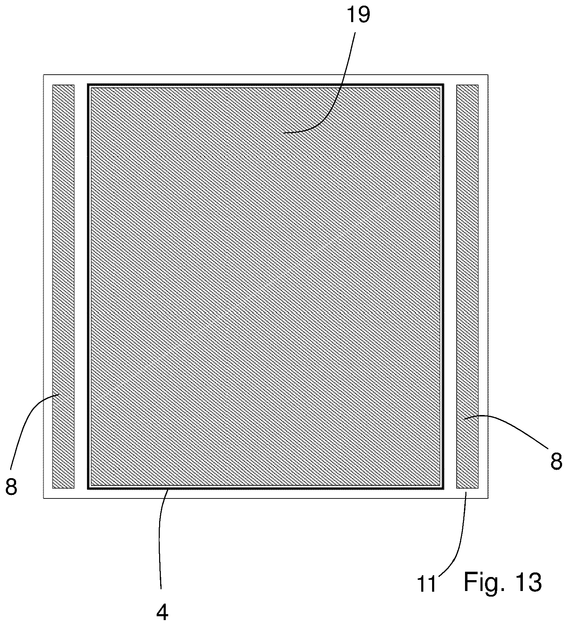

In the embodiment of figures 6 and 13, the semiconductor cover wafer 11 has an area which is larger than the area of the front surface 18 of the photovoltaic layer 4. Consequently, the semiconductor cover wafer 11 extends beyond the boarders of the photovoltaic layer 4 in a lateral direction 23. Thus, the projection of the semiconductor cover wafer 11 beyond the lateral extension of the photovoltaic layer 4 enables to provide the busbar metallization 8 on a back surface 12 of the semiconductor cover wafer 11.

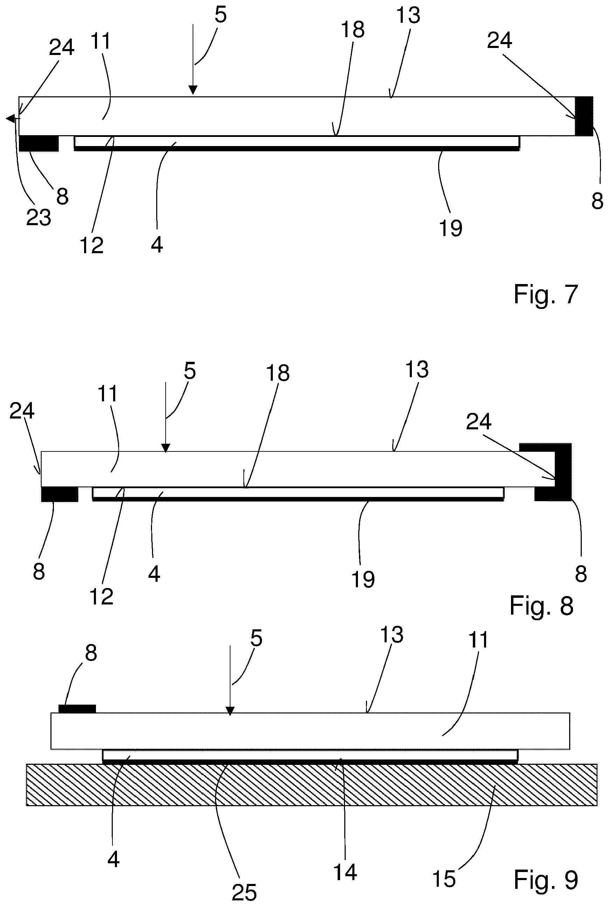

Alternatively or additionally, the busbar metallization 8 may be provided on a side surface 24 of the semiconductor cover wafer 11 (figures 7 and 8). By providing access for the busbar metallization 8 at the back or side of the photovoltaic power converter chip, flip chip type, one side assembly can be carried out for the electrical contact terminals of the photovoltaic power converter chip.

Alternatively or additionally, the busbar metallization 8 may be provided on the front surface 13 of the semiconductor cover wafer 11 as shown in figure 9.

The embodiments of figures 9 to 11 comprise a reflector on the back surface 14 of the photovoltaic layer 4 to reflect the electromagnetic radiation 5 having passed the photovoltaic layer 4 back into the photovoltaic layer. This enhances the overall conversion efficiency of the device 10. In the embodiment of figure 9 the reflector is provided by a metallic coating 25 between the photovoltaic power converter 4 and a back carrier 15. In the embodiment of figure 10 the reflector is provided by a distributed Bragg reflector 26 between the photovoltaic power converter 4 and a back carrier 15. In the embodiment of figure 11 the reflector is provided by a dielectric coating 27 between the photovoltaic power converter 4 and a back carrier 15. A sufficient electrical back contact is implemented by conducting vias 28 electrically connecting the back carrier 15 to the photovoltaic layer 4.

For purposes of original disclosure, it is pointed out that all features which are apparent for a person skilled in the art from the present description, the figures and the claims, even if they have only been described with further features, could be combined on their own or together with all the combinations of the features disclosed herein, if not excluded explicitly or technically impossible. A comprehensive explicit description of all possible combinations of features is only omitted in order to provide readability of the description.

While the disclosure has been described with respect to a limited number of embodiments, it will be understood that the disclosure is not limited to those embodiments. Other embodiments comprising various changes do not depart from the scope of the disclosure. In particular, the description of preferred embodiments shall not be understood to be limited to what is explicitly shown and described in the specification and drawings but shall encompass the disclosure of the specification and drawings as a whole.

### Reference numbers

- 1: photovoltaic power converter
- 2: semiconductor substrate
- 3: front surface
- 4: photovoltaic layer
- 5: electromagnetic radiation
- 6: contact metallization
- 7: front surface
- 8: busbar metallization
- 9: contact finger metallization
- 10: photovoltaic power converter
- 11: semiconductor cover wafer
- 12: back surface of the semiconductor cover wafer 11
- 13: front surface of the semiconductor cover wafer 11
- 14: back surface of the photovoltaic layer 4
- 15: back carrier
- 16: front surface of the semiconductor substrate wafer 17
- 17: semiconductor substrate wafer
- 18: front surface of the photovoltaic layer 4
- 19: back contact
- 20: heat dissipator
- 23: lateral direction
- 24: side surface
- 25: metallic coating
- 26: distributed Bragg reflector
- 27: dielectric coating
- 28: via

## Claims

1. A photovoltaic power converter (10) comprising
a photovoltaic layer (4),
wherein the photovoltaic layer (4) comprises a semiconductor junction, and
wherein the photovoltaic layer (4) is designed for absorbing an electromagnetic radiation (5) in a wavelength range,
at least part of a semiconductor cover wafer (11),
wherein the semiconductor cover wafer (11) is transparent for the electromagnetic radiation (5) in the wavelength range, and
wherein the semiconductor cover wafer (11) is electrically conductive,
and a contact metallization (6),
wherein the contact metallization (6) is in electrical contact with the semiconductor cover wafer (11).

2. The photovoltaic power converter (10) according to the previous claim, wherein the semiconductor cover wafer (11) has a resistivity of 1 · 10⁴ Ohm cm or less, preferably of 1 · 10² Ohm cm or less.

3. The photovoltaic power converter (10) according to anyone of the previous claims, wherein the semiconductor cover wafer (11) comprises an area which in a lateral direction extends beyond an area of the photovoltaic layer (4), and wherein at least part of the contact metallization (6) is provided on a back surface (12) of the semiconductor cover wafer (11).

4. The photovoltaic power converter (10) according to anyone of the previous claims, wherein the photovoltaic layer (4) comprises a total area, wherein the contact metallization (6) comprises a busbar metallization (8) and optionally a contact finger metallization (9), which contact finger metallization (9) is electrically connected to the busbar metallization (8), wherein an active chip area is defined as the total area of the photovoltaic layer (4) minus an area of the photovoltaic layer (4) covered by the busbar metallization (8), and wherein 10 % or less or 5 % or less or 3 % or less or 2 % or less or 1 % or less of the active chip area is covered by the contact finger metallization (9).

5. The photovoltaic power converter (10) according to anyone of the previous claims, wherein the semiconductor cover wafer (11) comprises a p-type doping or a n-type doping.

6. The photovoltaic power converter (10) according to anyone of the previous claims, wherein the photovoltaic layer (4) is obtained by epitaxial growth on the semiconductor cover wafer (11).

7. The photovoltaic power converter (10) according to anyone of the previous claims, wherein the semiconductor cover wafer (11) comprises GaAs, InP, Ge, InAs or GaSb such that the semiconductor cover wafer (11) is transparent for the electromagnetic radiation (5) in the wavelength range, wherein a smallest wavelength of the wavelength range is equal to or larger than 900 nm.

8. The photovoltaic power converter (10) according to anyone of the previous claims, wherein the semiconductor cover wafer (11) comprises Si such that the semiconductor cover wafer (11) is transparent for the electromagnetic radiation (5) in the wavelength range, wherein a smallest wavelength of the wavelength range is equal to or larger than 1100 nm.

9. The photovoltaic power converter (10) according to anyone of the previous claims, wherein the photovoltaic layer (4) or a semiconductor structure comprising the photovoltaic layer (4) is bonded onto a back carrier (15).

10. The photovoltaic power converter (10) according to the previous claim, wherein the back carrier (15) comprises a thermal conductivity being larger than a thermal conductivity of the photovoltaic layer (4).

11. The photovoltaic power converter (10) according to anyone of the previous claims, wherein on a side of the photovoltaic layer (4) opposite the semiconductor cover wafer a metallic coating or a dielectric coating or a distributed Bragg reflector is provided, which metallic coating or dielectric coating or distributed Bragg reflector reflects the electromagnetic radiation (5) in the wavelength range.

12. The photovoltaic power converter (10) according to anyone of claims 1 to 5 and 7 to 11, wherein the photovoltaic layer (4) is obtained by growth on a semiconductor substrate wafer (17), and wherein a semiconductor structure comprising the semiconductor cover wafer (11) is bonded onto a surface of the photovoltaic layer (4) opposite the semiconductor substrate wafer (17).

13. The photovoltaic power converter (10) according to the previous claim, wherein the semiconductor cover wafer (11) comprises GaAs, InP, Ge, InAs, GaSb, GaN, GaP, SiC, diamond or AllnGaN-on-sapphire, such that the semiconductor cover wafer (11) is transparent for the electromagnetic radiation (5).

14. The photovoltaic power converter (10) according to anyone of the previous claims, wherein the photovoltaic layer (4) comprises a plurality of vertically series connected semiconductor junctions.

15. Power-by-light system comprising
a source for the electromagnetic radiation (5), and
a photovoltaic power converter (10) according to anyone of the previous claims.
